# EUROPEAN PATENT APPLICATION

(11) **EP 0 554 569 A2**
(43) Date of publication of application: **11.08.1993**
(21) Application number: 92122109.9
(22) Date of filing: 29.12.1992
(51) Int. Cl.: H05B 33/00

(54) **Efficient organic electroluminescent device of simplified construction**

(30) Priority: 30.12.1991 US 814660
(71) Applicant: EASTMAN KODAK COMPANY, Rochester, New York 14650-2201 (US)
(72) Inventor: Littman, Jon Eric, c/o Eastman Kodak Company, Rochester, New York 14650-2201 (US)
(74) Representative: Brandes, Jürgen, Dr. rer. nat.

(57) **Abstract**

An organic electroluminescent device is disclosed comprised of, in sequence, an anode, an organic electroluminescent medium, and a cathode. The organic electroluminescent medium is formed by an organic host material capable of sustaining both hole and electron injection in contact with both the anode and the cathode and a fluorescent dye capable of emitting light in response to hole-electron recombination located in the host material and spaced from the cathode. The dye has a bandgap no greater than that of the host material and a reduction potential at least 0.4 volt less negative than that of the host material.

## Description

The invention relates to organic electroluminescent devices. More specifically, the invention relates to devices which emit light from an organic medium located between anode and cathode electrodes when a voltage is applied across the electrodes.

Based on investigations extending over the past three decades there has emerged a consensus in the art that the most efficient organic electroluminescent (or, more succinctly, EL) devices are those in which the organic EL medium has a thickness of less than 1 µm and is divided into two discrete zones, a hole injecting and transporting zone in contact with the anode and an electron injecting and transporting zone in contact with the cathode. The internal interface of the hole injecting and transporting zone with the electron injecting and transporting zone forms an internal junction. Hence this class of highly efficient organic EL devices are commonly referred to as internal junction organic EL devices. Luminescence typically occurs when holes from the hole injecting and transporting zone cross the junction into electron injecting and transporting zone. With efficient internal junction organic EL device constructions light outputs can be obtained that are compatible with viewing under ambient lighting while employing low driving voltages well within the capabilities of integrated circuit drivers, such as field effect transistors.

The following patents illustrate efficient internal junction organic EL device constructions:
R-1 US-A-4,356,429 discloses in Example 1 a transparent conductive anode on a glass support, a 1000 Å hole transporting layer of copper phthalocyanine, a 1000 Å electron transporting layer of tetraphenylbutadiene in poly(styrene) also acting as the luminescent zone of the device, and a silver cathode.
R-2 US-A-4,539,507 discloses an internal junction device construction particularly notable for the teaching of employing a metal chelate of 8-hydroxyquinoline to form the electron injecting and transporting zone.
R-3 US-A-4,720,432 discloses an internal junction device construction particularly notable for teaching to increase device stability by interposing an aromatic tertiary amine as a hole transporting layer between a hole injecting porphyrinic compound (for example, copper phthalocyanine) and the electron injecting and transporting zone.
R-4 US-A-5,061,569 improves on R-3 in the choice of the tertiary amine.
R-5 US-A-4,885,221
R-6 US-A-5,047,687
R-7 US-A-5,059,861
R-8 US-A-5,059,862
R-9 US-A-5,073,446

R-5 to R-9 disclose internal junction device constructions adding specific teachings relating to the cathode.
R-10 US-A-4,769,292 discloses internal junction device constructions particularly notable for the teaching of adding a fluorescent dye in the luminescent zone for the purpose of shifting the hue of light emission. The fluorescent dye has a bandgap no greater than that of the host material and a reduction potential less negative than that of the host material. At column 34, lines 33 to 36, Tang and others states, "As an alternative construction a separate layer containing the host material, but lacking the fluorescent material, can be interposed between the luminescent zone and the cathode." Tang and others further states in column 34, lines 64 to 67, "...either the layer forming the hole injecting zone or the layer forming the hole transporting zone can be omitted and the remaining layer will perform both functions." In either instance the device remains an internal junction device.

In one aspect the invention is directed to an organic electroluminescent device comprised of, in sequence, an anode, an organic electroluminescent medium of less than 1 µm in thickness, and a cathode.

The invention is characterized in that the organic electroluminescent medium consists essentially of (a) in contact with both the anode and the cathode an organic host material capable of sustaining both hole and electron injection and (b) located in the host material and spaced from the cathode a fluorescent dye capable of emitting light in response to hole-electron recombination. The dye has a bandgap no greater than that of the organic host material and a reduction potential at least 0.4 volt less negative than that of the host material.

It has been discovered quite unexpectedly that the performance of the internal junction organic EL device constructions can be can be approached employing a simpler construction containing no internal junction. Specifically, the efficiencies of internal junction organic EL devices can be approached without including in device construction a hole injecting and transporting zone.

The invention has been made possible by the discovery that an electron injecting and transporting zone alone interposed between the anode and cathode of a device can yield relatively high levels of efficiency when a fluorescent dye is introduced satisfying specific criteria:
(1) the fluorescent dye must be chosen to have a bandgap potential no greater than the host material;
(2) the fluorescent dye must be chosen to exhibit a reduction potential at least 0.4 V less negative than the reduction potential of the host material; and
(3) the fluorescent dye must be located in the host material at a location spaced from the cathode.

Although Tang and others recognized fluorescent dyes to be generally useful for shifting the hue of emission in internal junction organic EL devices, Tang and others failed to recognize that the combination of specific fluorescent dye selections based on reduction potential and placement could result in relatively high efficiency organic EL devices lacking an internal junction.

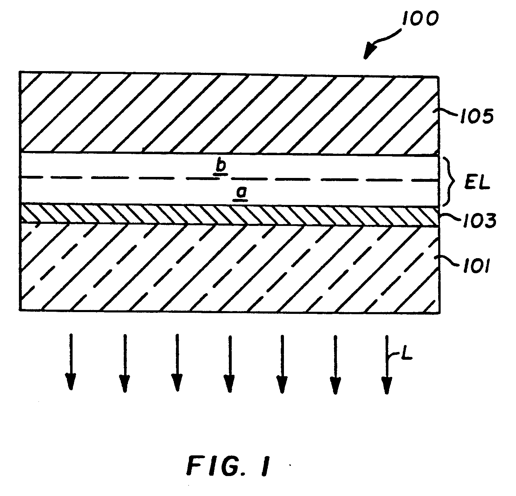

Figure 1 is a schematic diagram of an organic EL device satisfying the requirements of the invention.

An organic electroluminescent (or EL) device **100** according to the invention is schematically illustrated in Figure 1. A transparent support **101**, typically a plastic or, preferably, a glass support, has coated on its surface a light transmissive, preferably transparent, anode **103**. Overlying and in contact with the anode is an organic EL medium **EL**. Overlying and in contact with the organic EL medium is a cathode **105**.

The organic EL medium **EL** is divided into doped region **a** and an undoped region **b**. Both regions contain the same organic host material capable of sustaining both hole and electron injection. The host material can be a single compound or a mixture of compounds.

In the doped region **a** the organic EL medium additionally contains a fluorescent dye. The fluorescent dye is selected to have a bandgap no greater than that of the organic host material and a reduction potential at least 0.4 volt less negative than that of the host material. If the host material is made up of more than one compound, the bandgap and reduction potential of the fluorescent dye are referenced to the compound having the smallest bandgap potential difference.

In operation of the organic EL device **100** the cathode **105** is negatively biased relative to the anode **103**. Electrons are injected into the organic EL medium **EL** at the interface of region **b** with the cathode. Concurrently holes are injected into the organic EL medium at the interface of region **a** with the anode. potential. The fluorescent dye molecules in region **a** provide favored sites for hole-electron recombination because of the lower bandgap of the fluorescent dye. When an electron moves from a conduction band energy level into a hole in a valence band shell of the fluorescent dye, the energy given up by the electron is released in the form of light energy--that is, a photon. Light is emitted from the device through the light transmissive anode **103** and the transparent support **101**, as indicated by arrows **L**.

In a first comparative construction, when the device **100** is constructed as described above, but without the fluorescent dye present, an efficiency loss ranging from 1 to 2 orders of magnitude (that is, an efficiency in the range of from 1/10 to 1/100 that of the invention) is observed. It is believed that in the absence of the fluorescent dye a large proportion of electrons are migrating to the anode without releasing conduction band energy.

In a second comparative construction, when the device **100** is constructed as described above, but with the fluorescent dye uniformly distributed within the organic EL medium **EL**--that is, not excluded from region **b**, the efficiency of the device is also relatively low. It is believed that in this arrangement the close proximity of hole-electron recombination in region **b** to the cathode is resulting in light quenching.

In comparing the performance and structure of the device **100** to the first and second comparative constructions it is believed that at least one basis for the advantage provided by the structure of device **100** is that hole-electron recombination is better confined to the bulk of the organic EL medium and that this results in a higher ratio of photon release to input energy.

However, not every fluorescent dye having a bandgap potential no greater than that of the host material and a reduction potential less negative than that of the host material is effective to increase device efficiency. When the bandgap potential of the fluorescent dye equals that of the host material, the fluorescent dye participates in hole-electron recombination and influences the hue of emission by the wavelength of the photons emitted by the fluorescent dye. When the bandgap potential of the fluorescent dye is significantly less than that of the host material, the fluorescent dye provides a favored emission site and itself determines the hue of emission.

However, even though a fluorescent dye is effective in shifting the hue of device emission, it may not significantly improve the efficiency of the device in terms of photons released as a function of input energy. It has been discovered quite unexpectedly that, when the reduction potential of the fluorescent dye is at least 0.4 V more positive than the reduction potential of the host material, a significant increase in emission efficiency as a function of input energy can be realized. Even larger enhancements in efficiency are realized when the reduction potential of the fluorescent dye is at least 0.45 V more positive than the reduction potential of the host material.

In constructing the device **100** the anode **103** is preferably constructed of an electrically conductive light transmissive layer of indium tin oxide and the support **101** is preferably a transparent glass support. However, any conventional choice of anode and support is contemplated. For example, any of the selections set out in R-1 to R-10, cited above and here incorporated by reference, is specifically contemplated. Instead of employing indium tin oxide, tin oxide or a similar electrically conductive transparent oxide, the anode can be formed of thin, light transmissive layers of any of the high (for example, greater than 4.0 eV) work function metals. Listings of high work function metals are included in US-A-4,720,432. Chromium and gold mixtures are particularly contemplated for forming the anode.

The host material of the organic EL medium can be selected from among any of the organic materials employed to form the electron injecting and transporting zone of the organic EL devices of R-1 to R-9, cited above and here incorporated by reference.

In one specifically preferred form host material is a metal oxinoid charge accepting compound satisfying the formula: 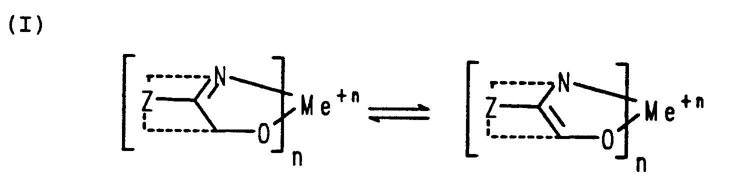
where
Me represents a metal,
n is an integer of from 1 to 3, and
Z represents the atoms necessary to complete an oxine nucleus.

Illustrative of useful chelated oxinoid compounds are the following:
CO-1 Aluminum trisoxine
CO-2 Magnesium bisoxine
CO-3 Bis[benzo{f}-8-quinolinolato] zinc
CO-4 Aluminum tris(5-methyloxine)
CO-5 Indium trisoxine
CO-6 Lithium oxine
CO-7 Gallium tris(5-chlorooxine)
CO-8 Calcium bis(5-chlorooxine)
CO-9 Poly[zinc (II)-bis(8-hydroxy-5-quinolinyl)methane]
CO-10 Dilithium epindolidione
CO-11 Aluminum tris(4-methyloxine)
CO-12 Aluminum tris(6-trifluoromethyloxine)
Of the various metal oxinoids, the most highly preferred are the tris-chelates of aluminum. These chelates are formed by reacting three 8-hydroxyquinoline moieties with a single aluminum atom. Aluminum trisoxine [a.k.a., tris(8-quinolinol) aluminum] and aluminum tris(5-methyloxine) [a.k.a. tris(5-methyl-8-quinolinol) aluminum] are two specifically preferred chelates.

Another preferred host material is disclosed by VanSlyke and others U.S. Serial No. 738,777, filed Jan. 8, 1991, commonly assigned, titled IMPROVED BLUE EMITTING INTERNAL JUNCTION ORGANIC ELECTROLUMINESCENT DEVICE (III). In a specifically preferred form the mixed ligand aluminum chelates therein disclosed include bis (R^{s}-8-quinolinolato)(phenolato)aluminum(III) chelate, where R^{s} is a ring substituent of the 8-quinolinolato ring nucleus chosen to block the attachment of more than two 8-quinolino-lato ligands to the aluminum atom. These compounds can be represented by the formula:

(II) (R^{s}-Q)₂-Al-O-L

where
Q in each occurrence represents a substituted 8-quinolinolato ligand,
R^{s} represents an 8-quinolinolato ring substituent chosen to block sterically the attachment of more than two substituted 8-quinolinolato ligands to the aluminum atom,
O-L is phenolato ligand, and
L is a hydrocarbon of from 6 to 24 carbon atoms comprised of a phenyl moiety.
As employed herein the term "phenolato ligand" is employed in its art recognized usage to mean a ligand bonded to the aluminum atom by the deprotonated hydroxyl group of a phenol.

In its simplest form the phenolato ligand can be provided by deprononation of hydroxybenzene. Preferred phenolato ligands for the aluminum chelates of formula II are derived from HO-L phenols, where L is a hydrocarbon of from 6 to 24 carbon atoms comprised of a phenyl moiety. This includes not only hydroxybenzene, but a variety of hydrocarbon substituted hydroxybenzenes, hydroxynaphthalenes and other fused ring hydrocarbons. Since monomethyl substitution of the phenyl moiety shorten emission wavelengths, it is preferred that the phenolato ligand contain at least 7 carbon atoms. Generally there is little advantage to be gained by employing phenolato ligands with very large numbers of carbon atoms. However, investigations of phenolato ligands with 18 aromatic ring carbon atoms have revealed high levels of stability. Thus, the phenolato ligands preferably contain from 7 to 18 total carbon atoms.

Aliphatic substituents of the phenyl moiety of phenolato ligand are contemplated to contain from 1 to 12 carbon atoms each. Alkyl phenyl moiety substituents of from 1 to 3 carbon atoms are specifically preferred, with the best overall characteristics having been observed to be produced with methyl substituents.

Aromatic hydrocarbon substituents of the phenyl moiety are preferably phenyl or naphthyl rings. Phenyl, diphenyl and triphenyl substitution of the phenyl moiety have all been observed to produce highly desirable organic EL device characteristics.

Phenolato ligands derived from α or β naphthols have been observed to produce aluminum chelates of exceptional levels of stability. A limited degree of emission shifting to shorter wavelengths is also realized, similar to that exhibited by hydroxybenzene derived phenolato ligands. By employing naphtholato ligand containing aluminum chelates in combination with blue emitting fluorescent dyes, described below, highly desirable device constructions are possible.

From comparisons of *ort*h*o*, *meta* and *para* substituted homologues of the various phenolato ligands it has been determined that little, if any, difference in performance is attributable to the position on the phenyl moiety ring occupied by the hydrocarbon substituent.

In a preferred form the aluminum chelates satisfy the following formula: 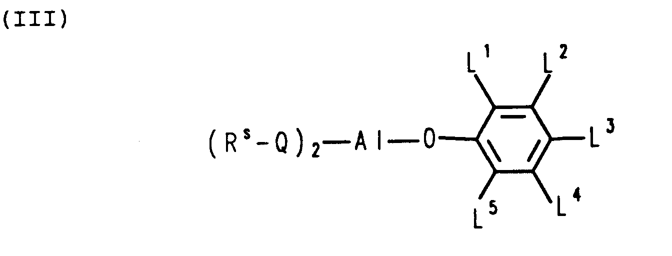
where
Q and R^{s} are as defined above and
L¹, L², L³, L⁴ and L⁵ collectively contain 12 or fewer carbon atoms and each independently represent hydrogen or hydrocarbon groups of from 1 to 12 carbon atoms, with the proviso that L¹ and L² together or L² and L³ together can form a fused benzo ring.

Although either or both of the 8-quinolinolato rings can contain substituents other than the steric blocking substituent, further substitution of the rings is not required. It is appreciated further that more than one substituent per ring can contribute to steric blocking. The various steric blocking substituent possibilities are most easily visualized by reference to the following formula: 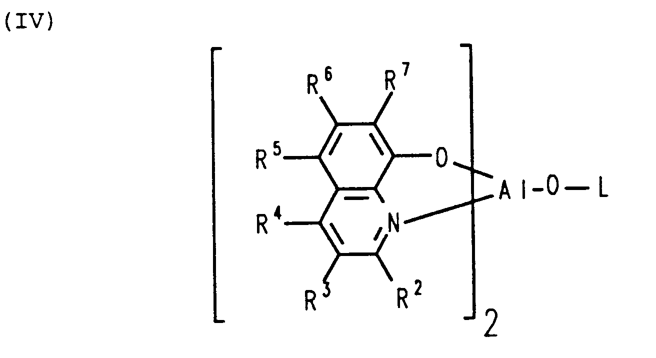
where L can take any form described above and R² to R⁷ represent substitutional possibilities at each of ring positions 2 to 7 inclusive of the 8-quinolinolato rings. Substituents at the 4, 5 and 6 ring positions are not favorably located to hinder sterically the bonding of three 8-quinolinolato nuclei to a single aluminum atom. While it is contemplated that large substituents at the 3 or 7 ring positions could provide sufficient steric hindrance, the incorporation of bulky substituents substantially increases molecular weight without enhancing molecular performance and therefore detracts from overall performance. On the other hand, the 2 ring position is suited to provide steric hindrance, and even a very small substituent (for example, a methyl group) in one of these ring positions provides an effective steric blocking substituent. For synthetic convenience it is specifically preferred that steric blocking substituents be located in the 2 ring positions. As employed herein the term "steric blocking" is employed to indicate that the R^{s}-Q ligand is incapable of competing for inclusion as the third ligand of the aluminum atom.

R² is preferably an amino, oxy or hydrocarbon substituent. Adequate steric hindrance is provided when R² is methyl and is the sole 8-quinolinolato ring substituent (that is, each of R³, R⁴, R⁵, R⁶ and R⁷ is hydrogen). Thus, any amino, oxy or hydrocarbon substituent having at least 1 carbon atom falls within the preview of preferred substituents. Preferably no more than 10 carbon atoms are present in any one hydrocarbon moiety and optimally no more than 6 carbon atoms. Thus, R² preferably takes the form of -R', -OR' or -N(R'')R', where R' is a hydrocarbon of from 1 to 10 carbon atoms and R'' is R' or hydrogen. Preferably R² contains 10 or fewer carbon atoms and optimally 6 or fewer carbon atoms.

R³ and R⁴ can take a broader range of forms than R², but are specifically contemplated to be selected from among the same group of preferred substituents as R². Since 3 and 4 ring position substitution is not required, R³ and R⁴ can additionally be hydrogen.

Since 5, 6 or 7 ring position substitution is not required, R⁵, R⁶ and R⁷ can represent hydrogen. In preferred forms R⁵, R⁶ and R⁷ can be selected from synthetically convenient electron accepting substituents, such as cyano, halogen, and α-haloalkyl, α-haloalkoxy, amido, sulfonyl, carbonyl, carbonyloxy and oxycarbonyl substituents containing up to 10 carbon atoms, most preferably 6 or fewer carbon atoms.

The following constitute specific examples of preferred mixed ligand aluminum chelates satisfying the requirements of the invention:
PC-1 Bis(2-methyl-8-quinolinolato)(phenolato)-aluminum(III) 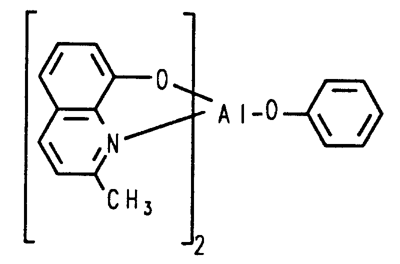
PC-2 Bis(2-methyl-8-quinolinolato)(*ortho*-cresolato)aluminum(III) 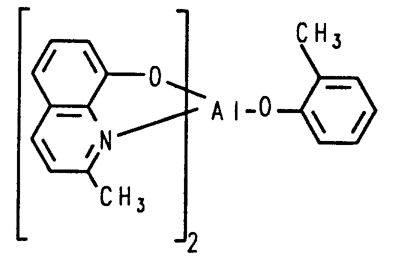
PC-3 Bis(2-methyl-8-quinolinolato)(*meta*-cresolato)aluminum(III) 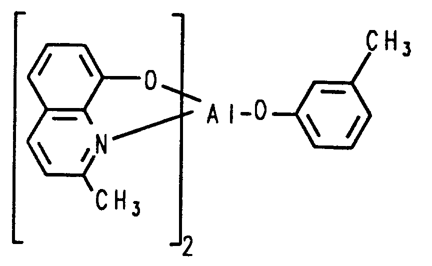
PC-4 Bis(2-methyl-8-quinolinolato)(*para*-cresolato)aluminum(III) 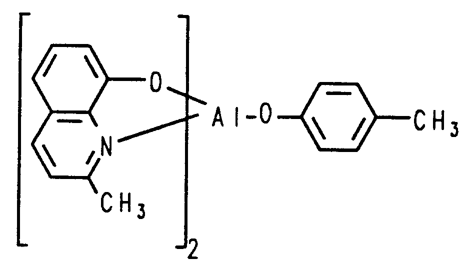
PC-5 Bis(2-methyl-8-quinolinolato)(*ortho*-phenylphenolato)aluminum(III) 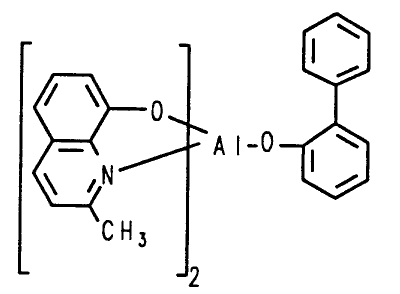
PC-6 Bis(2-methyl-8-quinolinolato)(*meta*-phenylphenolato)aluminum(III) 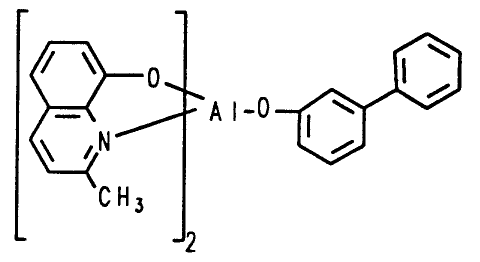
PC-7 Bis(2-methyl-8-quinolinolato)(*para*-phenylphenolato)aluminum(III) 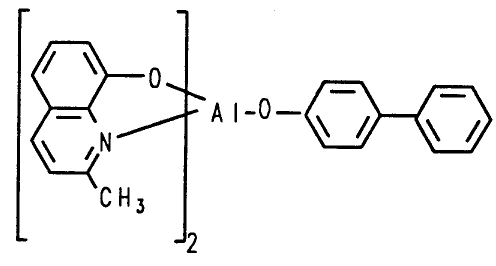
PC-8 Bis(2-methyl-8-quinolinolato)(2,3-dimethylphenolato)aluminum(III) 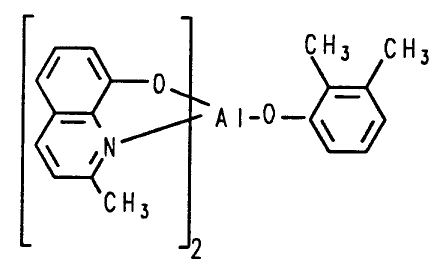
PC-9 Bis(2-methyl-8-quinolinolato)(2,6-dimethylphenolato)aluminum(III) 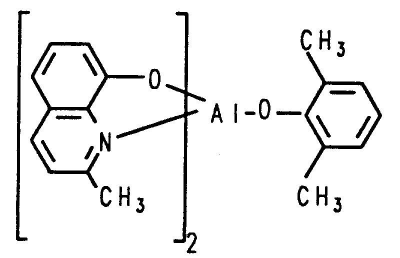
PC-10 Bis(2-methyl-8-quinolinolato)(3,4-dimethylphenolato)aluminum(III) 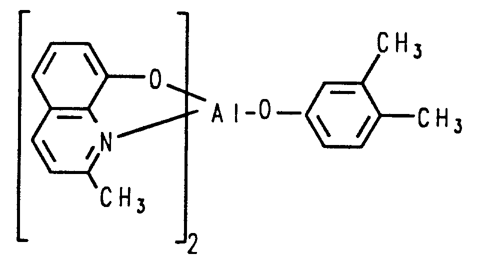
PC-11 Bis(2-methyl-8-quinolinolato)(3,5-dimethylphenolato)aluminum(III) 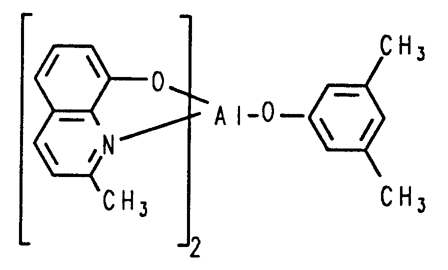
PC-12 Bis(2-methyl-8-quinolinolato)(3,5-di-*tert*-butylphenolato)aluminum(III) 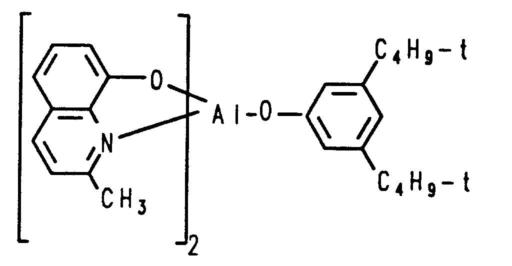
PC-13 Bis(2-methyl-8-quinolinolato)(2,6-diphenylphenolato)aluminum(III) 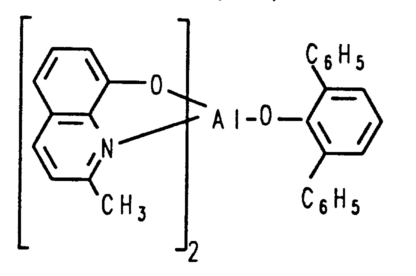
PC-14 Bis(2-methyl-8-quinolinolato)(2,4,6-triphenylphenolato)aluminum(III) 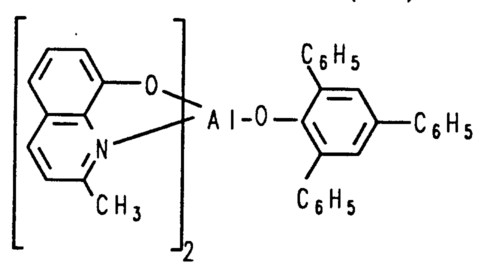
PC-15 Bis(2-methyl-8-quinolinolato)(2,3,6-trimethylphenolato)aluminum(III) 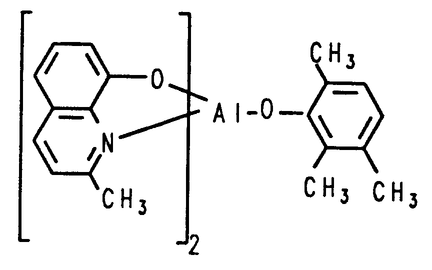
PC-16 Bis(2-methyl-8-quinolinolato)(2,3,5,6-tetramethylphenolato)aluminum(III) 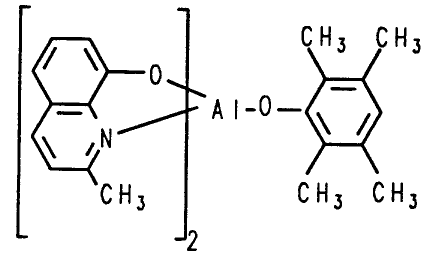
PC-17 Bis(2-methyl-8-quinolinolato)(1-naphtholato)aluminum(III) 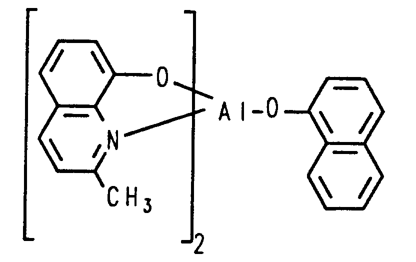
PC-18 Bis(2-methyl-8-quinolinolato)(2-naphtholato)aluminum(III) 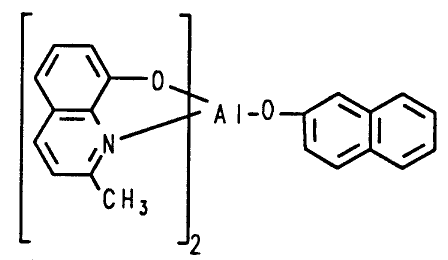
PC-19 Bis(2,4-dimethyl-8-quinolinolato)(*ortho*-phenylphenolato)aluminum(III) 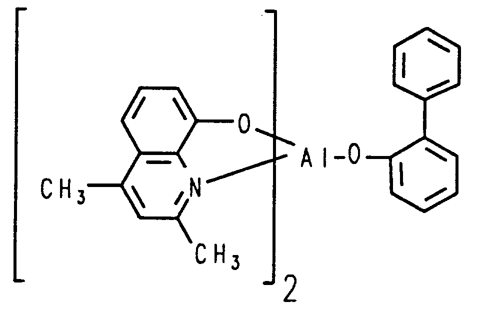
PC-20 Bis(2,4-dimethyl-8-quinolinolato)(*para*-phenylphenolato)aluminum(III) 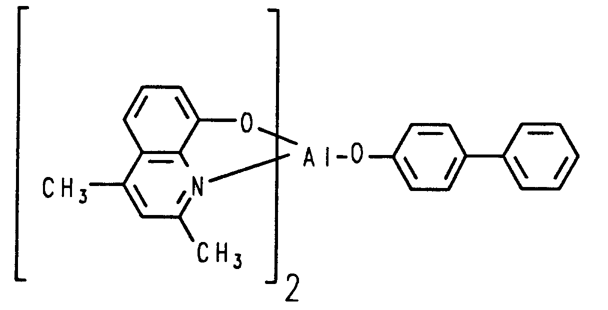
PC-21 Bis(2,4-dimethyl-8-quinolinolato)(*meta*-phenylphenolato)aluminum(III) 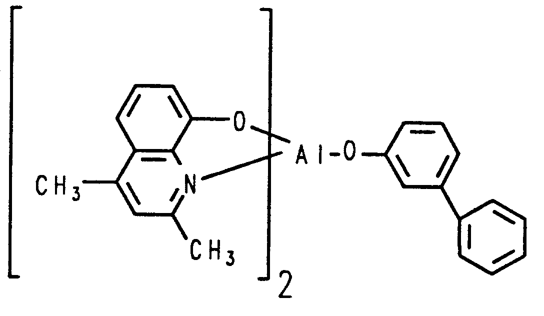
PC-22 Bis(2,4-dimethyl-8-quinolinolato)(3,5-dimethylphenolato)aluminum(III) 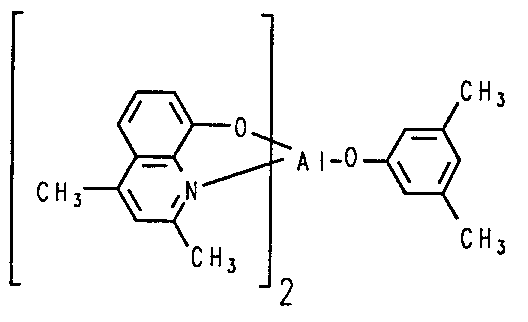
PC-23 Bis(2,4-dimethyl-8-quinolinolato)(3,5-di-*tert*-butylphenolato)aluminum(III) 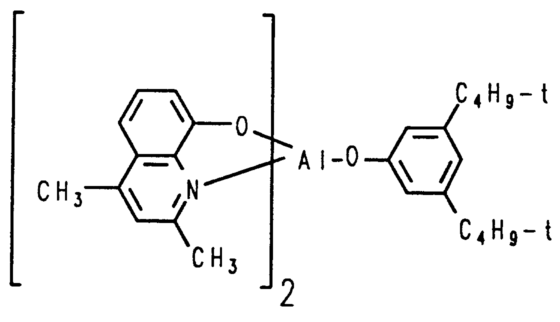
PC-24 Bis(2-methyl-4-ethyl-8-quinolinolato)(*para*-cresolato)aluminum(III) 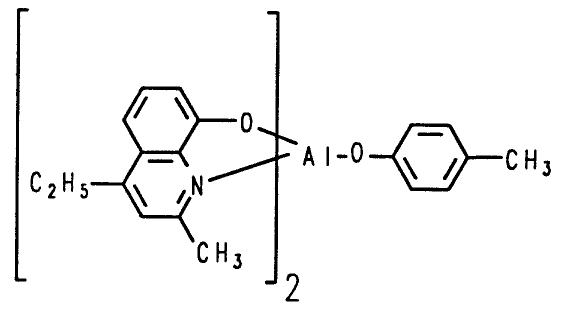
PC-25 Bis(2-methyl-4-methoxy-8-quinolinolato)(*para*-phenylphenylato)aluminum(III) 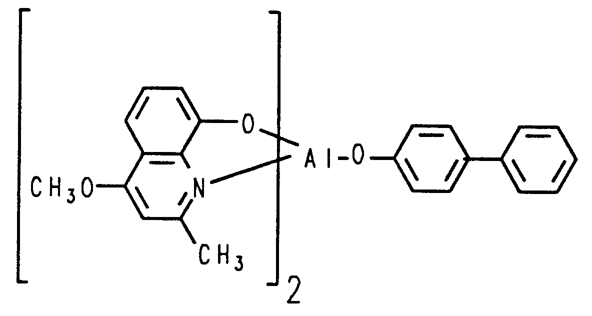
PC-26 Bis(2-methyl-5-cyano-8-quinolinolato)(*ortho*-cresolato)aluminum(III) 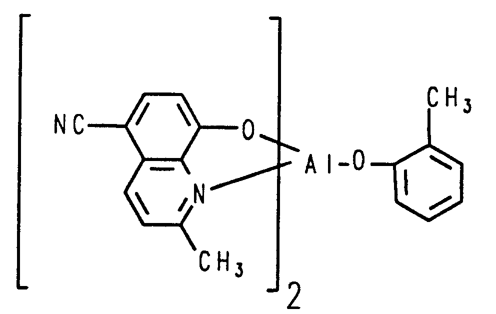
PC-27 Bis(2-methyl-6-trifluoromethyl-8-quinolinolato)(2-naphtholato)aluminum(III) 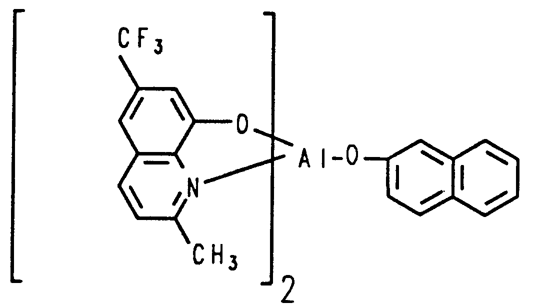
Instead of employing a bis(R^{s}-8-quinolinolato)(phenolato)aluminum(III)chelate as described above it is alternatively contemplated to employ a bis(R^{s}-8-quinolinolato)aluminum(III)-µ-oxo-bis(R^{s}-8-quinolinolato)aluminum(III) compound. The use of these compounds in organic EL devices is taught by VanSlyke U.S. Serial No. 738,776, filed Jan. 8, 1991, commonly assigned, titled IMPROVED BLUE EMITTING INTERNAL JUNCTION ORGANIC ELECTROLUMINESCENT DEVICE (I). These compounds broadly satisfy the formula:

(V) (R^{s}-Q)₂-Al-O-Al-(Q-R^{s})₂

and in a specific preferred form satisfy the formula: 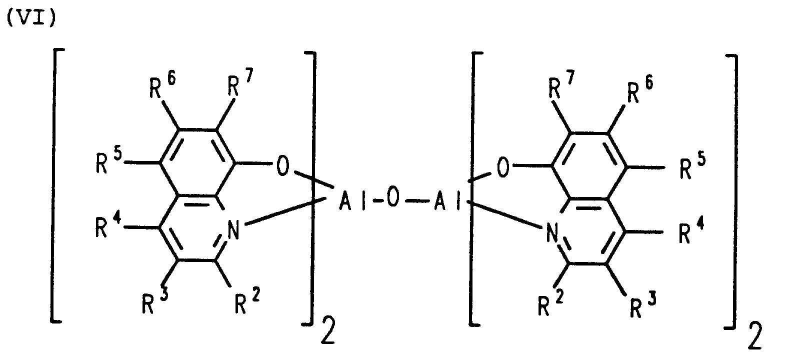
where Q, R^{s} and R² to R⁷ are as previously described in connection with formula II and IV.

The following constitute specific examples of preferred compounds satisfying formula V and VI:
BA-1 Bis(2-methyl-8-quinolinolato)aluminum(III)-µ-oxo-bis(2-methyl-8-quinolinolato)aluminum(III) 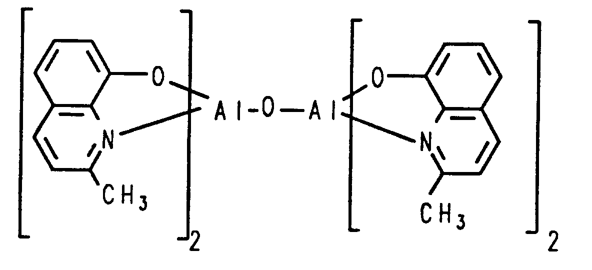
BA-2 Bis(2,4-dimethyl-8-quinolinolato)aluminum(III)-µ-oxo-bis(2,4-dimethyl-8-quinolinolato)aluminum(III) 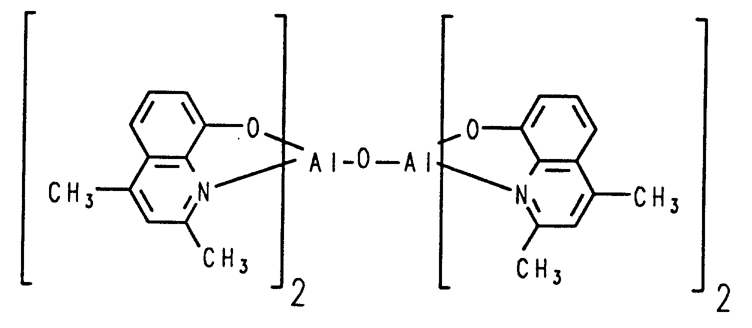
BA-3 Bis(4-ethyl-2-methyl-8-quinolinolato)aluminum(III)-µ-oxo-bis(4-ethyl-2-methyl-8-quinolinolato)aluminum(III) 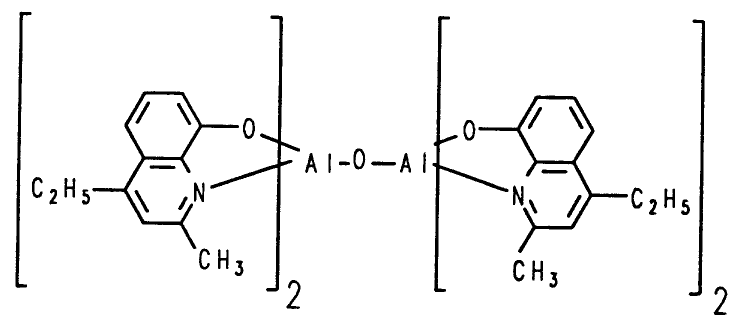
BA-4 Bis(2-methyl-4-methoxyquinolinoato)aluminum(III)-µ-oxo-bis(2-methyl-4-methoxyquinolinolato)aluminum(III) 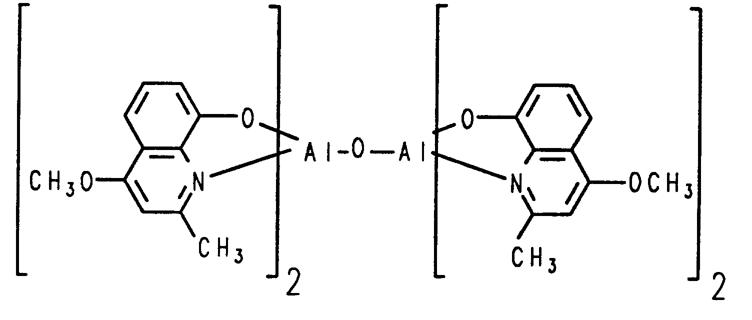
BA-5 Bis(5-cyano-2-methyl-8-quinolinolato)aluminum(III)-µ-oxo-bis(5-cyano-2-methyl-8-quinolinolato)aluminum(III) 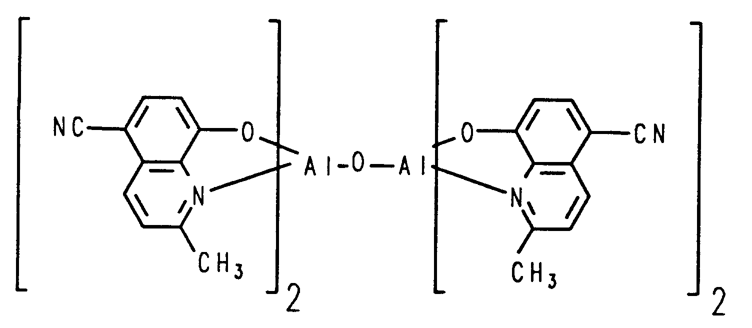
BA-6 Bis(2-methyl-5-trifluoromethyl-8-quinolinolato)aluminum(III)-µ-oxo-bis(2-methyl-5-trifluoromethylquinolinolato)aluminum(III)

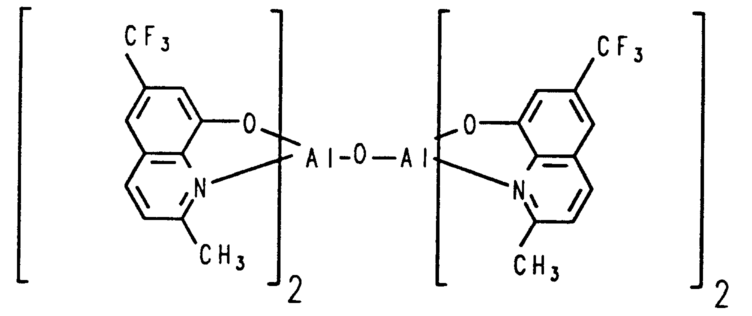

When one of the compounds of formula II to IV is employed as the host compound, it has been observed that improved performance can be obtained by the **b** region of the organic EL medium of one or a combination of the metal oxinoid compounds of formula I.

The fluorescent dye or dyes incorporated in the **a** region of the organic EL medium can be selected from among a large variety of known fluorescent dyes. For example, useful fluorescent dyes can be selected from among coumarin dyes, 4-dicyanomethylene-4H-pyrans and 4-dicyanomethylene-4H-thiopyrans, polymethine dyes (including cyanines, merocyanines, complex cyanines and merocyanines, oxonols, hemioxonols, styryls, merostyryls and streptocyanines), 4-oxo-4H-benz[d,e]anthracene dyes, xanthene dyes (including rhodamines and fluoresceins), pyrylium, thiapyrylium, selenapyrylium and telluropyrylium dyes, carbostyril dyes, perylene dyes, acridine dyes, bis(styryl)benzene dyes, pyrene dyes, oxaine dyes and phenyleneoxide dyes. All of these classes of dyes are within the general teachings of US-A-4,769,292, the disclosure of which is here incorporated by reference.

The specific choice of one or more fluorescent dyes is dependent upon the hue of emission desired, since the fluorescent dye controls this property, and the specific choice of the host medium, since the fluorescent dye must be chosen to exhibit a reduction potential at least 0.4 volt less negative than that of the host material. Typical reduction potentials of dyes in the exemplary class categories set out above are set out in US-A-4,743,528, 4,743,529, 4,743,530 and 4,743,531, the disclosure of which are here incorporated by reference. Any conventional technique for measuring reduction potentials can be employed so long as the reduction potentials of the dyes and host materials are similarly measured, since it is the difference in the reduction potentials of the fluorescent dye and host material that is responsible for the advantages of the invention.

Extremely low levels of fluorescent dye are capable of visibly altering the hue of emission. US-A-4,769,292 suggests fluorescent dye concentrations as low as 10⁻³ mole percent. To significantly enhance the efficiency of performance it is preferred that the fluorescent dye be present in the **a** region of the organic EL medium in a concentration of at least 0.05 and optimally at least 0.2 mole percent, based on the combined amount of host and dye present. Fluorescent dye concentrations in the **a** region can range up to 10 mole percent or higher, but are preferably less than 5 mole percent.

Although the **b** region of the organic EL medium is preferably entirely free of the fluorescent dye or dyes incorporated in the **a** region, it is appreciated that very limited amounts of fluorescent dye, below the minimum levels set forth above, can be tolerated while still realizing the advantages of the invention.

To realize acceptable levels of efficiency the total thickness of the organic EL medium is in all instances less than 1 µm (10,000 Å) and in most instances less than 5000 Å. It is generally preferred that the overall thickness of the organic EL medium be at least 1000 Å. Highest performance efficiencies are realized when the **b** region of the organic EL medium is maintained at a minimum thickness--that is, at thickness that is just sufficient to prevent contact of the fluorescent dye containing **a** region with the cathode of the device. Although the **b** region of the device can range as low as 50 Å in thickness, it is generally preferred that the **b** region have a thickness in the range of from 100 to 1000 Å.

Although the cathode **105** can be formed of any metal or metals (other than an alkali metal) having a lower (<4.0 eV) work function alone or in combination with one or more higher (>4.0 eV) work function metals, it is preferred that the cathode be constructed as taught by US-A-4,885,432, the disclosure of which is here incorporated by reference. In a specifically preferred construction the cathode at its interface with the organic EL medium contains at least 50 percent magnesium and at least 0.1 percent (optimally at least 1 percent) of a metal, such as silver or aluminum, having a work function greater than 4.0 eV. After the metal has been deposited that forms an interface with the organic EL medium, the cathode can be thickened to increase its conductivity without decreasing its electron injecting efficiency by depositing any convenient metal. When a higher (>4.0 eV) metal is employed for this purpose the stability of the cathode is also increased.

### Examples

The practice of the invention can be better appreciated by reference to the following specific examples. A reduction potentials were measured versus a standard calomel electrode.

### Example 1 (A Control)

An organic EL device was constructed by evaporating 1200 Å of tris(8-hydroxyquinoline)aluminum chelate (reduction potential -1.79 V) onto an indium tin oxide coated surface of a glass substrate. A cathode 2000 Å in thickness was then vapor deposited over the organic EL medium. The cathode contained 90 percent magnesium on an elemental basis with silver accounting for the remaining 10 percent.

The quantum efficient of the organic EL device when operated at a light output level of 0.1 mW/cm² was quite low, only 0.002 photon/electron.

This control demonstrates the high inefficiencies observed when a single layer organic EL medium is employed, even when the organic EL medium consists of one of the materials most highly preferred for the construction of efficient internal junction organic EL devices.

### Example 2 (A Control)

An organic EL device was constructed as described in Example 1, except that the organic EL medium was constructed according to the teachings of US-A-4,769,292.

A hole injecting and transporting layer of 1,1,1-bsi(4-di-*p*-tolylaminophenyl)cyclohexane and a thickness of 300 Å was deposited onto the indium tin oxide anode. This was followed by a 600 Å layer of tris(8-hydroxyquinoline)aluminum chelate doped with 2 mole percent of the fluorescent dye 4-(dicyanomethylene)-2-methyl-6-(*p*-dimethylaminostyryl)-4H-pyran. This was followed by a 600 Å layer of tris(8-hydroxyquinoline)aluminum chelate lacking any incorporated fluorescent dye dopant.

When tested as described in Example 1, the device exhibited a much improved efficiency of 0.04 photon/electron. Note that this device is 20 times more efficient than the device of Example 1.

### Examples 3-5

It was discovered quite unexpectedly that the performance efficiency of the organic EL devices of Tang and others, illustrated by Example 2, can be approximated with a simplified device construction that is between 10 and 100 times more efficient than the device construction of Example 1. The devices were tested as described in Example 1.

### Example 3

Example 2 was repeated, except that the hole injecting and transporting layer was omitted.

The operating efficiency was 0.03 photon/electron. This is a 15 times improvement on the device of Example 1 and near the efficiency of the device of Example 2. However, unlike the device of Example 2, the device of this example was simpler to construct in that no hole injecting and transporting layer was deposited prior to depositing the tris(8-hydoxyquinoline)aluminum chelate.

### Example 4

Example 3 was repeated, except that 4-(dicyanomethylene)-2-methyl-6-(*p*-julolidylethyleneyl)-4H-pyran (reduction potential -1.34 V) was substituted as the fluorescent dye dopant. The operating efficiency was 0.03 photon/electron.

### Example 5

Example 3 was repeated, except that the following coumarin fluorescent dye (reduction potential -1.38 V) was substituted: 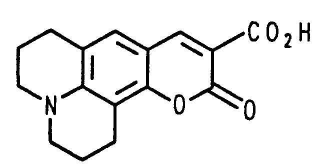
The performance efficiency was 0.009 photon/electron.

This Example demonstrates lower performance efficiencies than the previous examples of the invention. The reduction in performance efficiency is attributed to the difference in the reduction potentials of the dye and host being 0.41 V. However, the performance efficiency of this device was still higher than that of the device of Example 1.

### Example 6 (A Control)

Example 3 was repeated, except that the following dye (reduction potential -1.46 V) was substituted as the fluorescent dye: 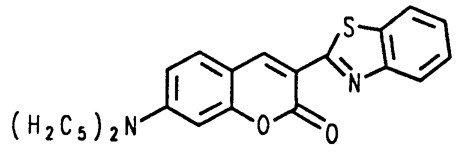
The performance efficiency was 0.004 photon/electron. The low performance efficiency is attributed to the relatively low difference in the reduction potentials of the fluorescent dye and the host, in this instance only 0.33 V.

Examples 5 and 6 demonstrate the importance of selecting a fluorescent dye having a reduction potential at least 0.40 V more positive than that of the host material.

## Claims

1. An organic electroluminescent device comprised of, in sequence, an anode, an organic electroluminescent medium of less than 1 µm in thickness, and a cathode,
CHARACTERIZED IN THAT the organic electroluminescent medium consists essentially of
in contact with both the anode and the cathode an organic host material capable of sustaining both hole and electron injection and
located in the host material and spaced from the cathode a fluorescent dye capable of emitting light in response to hole-electron recombination, the dye having a bandgap no greater than that of the organic host material and a reduction potential at least 0.4 volt less negative than that of the host material.

2. An organic electroluminescent device as claimed in 1 further characterized in that organic host material in contact with the anode and cathode is chosen from the class consisting of
(a) 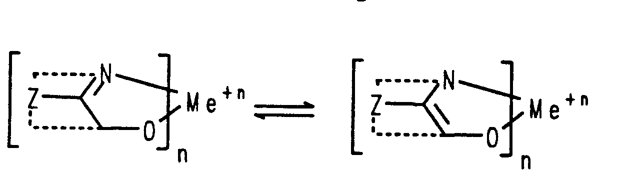
(b)
(R^{s}-Q)₂-Al-O-L
and
(c)
(R^{s}-Q)₂-Al-O-Al-(Q-R^{s})₂
where
L is a hydrocarbon of from 6 to 24 carbon atoms comprised of a phenyl moiety,
Me represents a metal,
n is an integer of from 1 to 3,
O-L is phenolato ligand, and
Q in each occurrence represents a substituted 8-quinolinolato ligand,
R^{s} represents an 8-quinolinolato ring substituent chosen to block sterically the attachment of more than two substituted 8-quinolinolato ligands to the aluminum atom, and
Z represents the atoms necessary to complete an oxine nucleus.

3. An organic electroluminescent device as claimed in 1 further characterized in that the dye has a reduction potential at least 0.45 volt less negative than that of the host material.

4. An organic electroluminescent device comprised of, in sequence, an anode, an organic electroluminescent medium of less than 1 µm in thickness, and a cathode,
CHARACTERIZED IN THAT the organic electroluminescent medium is comprised of a first region in contact with the cathode and a second region in contact with the anode,
the first region consists essentially of 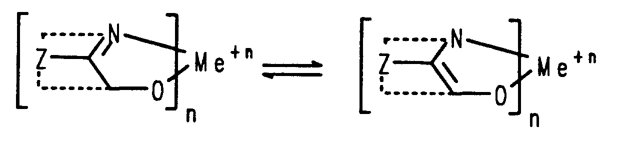 where
Me represents a metal,
n is an integer of from 1 to 3, and
Z represents the atoms necessary to complete an oxine nucleus, and
the second region consists essentially of a host material selected from among at least one of the following:
(a) 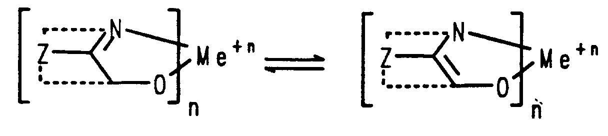
(b)
(R^{s}-Q)₂-Al-O-L
and
(c)
(R^{s}-Q)₂-Al-O-Al-(Q-R^{s})₂
where
L is a hydrocarbon of from 6 to 24 carbon atoms comprised of a phenyl moiety,
Me represents a metal,
n is an integer of from 1 to 3,
O-L is phenolato ligand, and
Q in each occurrence represents a substituted 8-quinolinolato ligand,
R^{s} represents an 8-quinolinolato ring substituent chosen to block sterically the attachment of more than two substituted 8-quinolinolato ligands to the aluminum atom, and
Z represents the atoms necessary to complete an oxine nucleus, and
a fluorescent dye capable of emitting light in response to hole-electron recombination, the dye having a bandgap no greater than that of the organic host material and a reduction potential at least 0.4 volt less negative than that of the host material.

5. An organic electroluminescent device as claimed in 4 further characterized in that the dye is a 4-dicyanomethylene-4H-pyran or 4-dicyano-methylene-4H-thiopyran.

6. An organic electroluminescent device as claimed in 4 further characterized in that the dye is a coumarin dye.
